# EUROPEAN PATENT SPECIFICATION

(11) **EP 4 511 324 B1**
(45) Date of publication and mention of the grant of the patent: **03.06.2026**
(21) Application number: 23718767.9
(22) Date of filing: 13.04.2023
(51) Int. Cl.: C01B 32/184, G02F 1/00, G02F 1/01

(54) **A GRAPHENE-CONTAINING LAMINATE**
GRAPHENHALTIGES LAMINAT
STRATIFIÉ CONTENANT DU GRAPHÈNE

(30) Priority: 21.04.2022 GB 202205824
(43) Date of publication of application: 26.02.2025
(73) Proprietor: Paragraf Limited, Cambridgeshire PE28 3EB (GB)
(72) Inventor: DIXON, Sebastian, Cambridgeshire PE28 3EB (GB); KAINTH, Jaspreet, Cambridgeshire PE28 3EB (GB); BADCOCK, Thomas James, Cambridgeshire PE28 3EB (GB); WALLIS, Robert, Cambridgeshire PE28 3EB (GB); MCDONNELL, Liam, Cambridgeshire PE28 3EB (GB)
(74) Representative: Boult Wade Tennant LLP
(86) International application number: PCT/EP2023/059679
(87) International publication number: WO 2023/202944

(56) References cited:
- EP-B1- 3 334 854
- CN-A- 105 803 403
- CN-A- 113 885 230
- US-A1- 2019 155 068
- RENÉ H. J. VERVUURT ET AL: "Atomic Layer Deposition for Graphene Device Integration", ADVANCED MATERIALS INTERFACES, vol. 4, no. 18, 26 May 2017 (2017-05-26), DE, pages 1700232, XP055709050, ISSN: 2196-7350, DOI: 10.1002/admi.201700232

## Description

The present invention relates to a graphene-containing laminate and a method of forming a graphene-containing laminate. More particularly, the graphene-containing laminate comprises metal oxide sandwiched by first and second graphene layer structures, the first graphene layer structure being on a substrate. The present invention also relates to electronic devices comprising said laminate, such as transistors and capacitors and, in particular, photonic devices such as electro-optic modulators and photodetectors.

Graphene is a leading two-dimensional material that has been incorporated in numerous products for its extraordinary properties. The electronic properties of graphene are especially remarkable and has allowed for the production of electronic devices (particularly microelectronics) that demonstrate properties that are orders of magnitude better than those of their non-graphene counterparts.

Graphene also exhibits unique optical properties such that graphene has been used in photonic and plasmonic devices such as electro-optic modulators (EOMs); these are devices which can be used to control the power or amplitude, phase, frequency, or the polarisation of light with an electrical control signal.

The preparation of sufficiently large area graphene with high uniformity has been major problem in the art which has hindered the uptake of graphene in commercial processes and ultimately electronic devices. The standard in the art is to manufacture graphene by CVD on copper foils or other catalytic metal substrates. A significant proportion of research and development has since focussed on the need to optimise the process by which graphene is transferred from such substrates to those of interest for electronic devices (i.e. non-metallic substrates, for example semiconductors such as silicon and insulators such as sapphire).

However, the inventors found that graphene grown on copper is inevitably contaminated, if not with copper, at least with the additional materials which are essential to effect the transfer. These include transfer polymers such as PMMA, metal etchants and solvents to remove the polymer. Polymer residues are however never fully removed and graphene provided by such methods cannot be devoid of transfer polymers and/or copper. Additionally, the physical manipulation of the graphene during transfer leads to defects in the atomically thin material.

Photonics 2022, 9(2), 82 "Silicon-Based Graphene Electro-Optical Modulators" provides a recent review of graphene EOMs and concludes that for commercial manufacturing, a reliable transfer method is still required to maintain mobility, coverage and continuity and well as for the placement of graphene during transfer.

Various EOMs are improved by providing a graphene-oxide-graphene (GOG) structure whereby the form of a capacitor improves modulation speed and reduce insertion loss, for example. CLEO: 2015, OSA Technical Digest (online) (Optica Publishing Group, 2015), paper SW4I.4 "30 GHz Zeno-based Graphene Electro-optic Modulator" and *Nanophotonics* **2021,** *10*(1), 99 "High-performance integrated graphene electro-optic modulator at cryogenic temperature" disclose graphene EOMs comprising a dual-layer graphene capacitor integrated with a silicon nitride waveguide, the graphene sheets separated by an alumina layer. The graphene is CVD grown on a copper substrate and transferred by electrochemical delamination. WO 2016/073995 A1 relates to the same subject-matter sharing the same inventors and authors.

US 10,775,651 B2 discloses double-layer graphene optical modulators and methods of fabrication thereof. The device includes a substrate, a first electrically insulating material disposed over the substrate, a first graphene layer and a second graphene layer disposed in the first electrically insulating material and being separated by the first electrically insulating material. A waveguide is disposed on the first electrically insulating material wherein the waveguide overlays both the first and second graphene layers.

Adv. Mater. Interfaces 2017, 4, 1700232 "Atomic Layer Deposition for Graphene Device Integration" provides an in-depth overview regarding the growth of dielectric layers by ALD on graphene. Dielectric layers are key components of electronic devices, ALD is in various circumstances the preferred method of deposition since it can provide thin films of uniform thickness. This review looks at ALD on pristine graphene as well as on graphene having had "surface preparation" such as through the use of polymer, metal or metal oxide seed layers or surface functionalisation. *C*. 2019, 5(3), 53 "Recent Advances in Seeded and Seed-Layer-Free Atomic Layer Deposition of High-K Dielectrics on Graphene for Electronics" reviews recent developments of ALD of high-k dielectrics on graphene with "in-situ" seed-layer approaches.

Appl. Phys. Lett. 2009, 94, 062107 "Realization of a high mobility dual-gated graphene field-effect transistor with Al2O3 dielectric" discloses to a top-gated graphene field-effect transistor with a high-k dielectric layer grown by ALD.

CN 113885230 A relates to a double-core optical fiber electro-optic modulator based on double-layer graphene.

US2019/155068 A1 discloses a method of fabricating a graphene-containing laminate with two graphene layers and a metaloxide layer therebetween; it also doscloses that the layers can be formed by CVD.

It is also known in the art that graphene may be synthesised, manufactured, formed, directly on non-metallic surfaces of substrates. The present inventors have found that the most effective method for manufacturing high-quality graphene, especially directly on such non-metallic surfaces, is that disclosed in WO 2017/029470. This publication discloses methods for manufacturing graphene; principally these rely on heating a substrate held within a reaction chamber to a temperature that is within a decomposition range of a carbon based precursor for graphene growth, introducing the precursor into the reaction chamber through a relatively cool inlet so as to establish a sufficiently steep thermal gradient that extends away from the substrate surface towards the point at which the precursor enters the reaction chamber such that the fraction of precursor that reacts in the gas phase is low enough to allow the formation of graphene from carbon released from the decomposed precursor. Preferably the apparatus comprises a showerhead having a plurality of precursor entry points or inlets, the separation of which from the substrate surface may be varied and is preferably less than 100 mm. The method of WO 2017/029470 is ideally performed using an MOCVD reactor. Whilst MOCVD stands for metal organic chemical vapour deposition due to its origins for the purposes of manufacturing semiconductor materials, such apparatus and reactors are well known and understood to those skilled in the art as being suitable for use with non-metal organic precursors.

Whilst the method of WO 2017/029470 enables the production of high-quality graphene with excellent uniformity and a constant number of layers (as desired) across its whole area on the substrate without additional carbon fragments or islands, such a thermal CVD process involves the high temperature deposition of graphene and the inventors encountered numerous problems when seeking to form a second graphene layer structure on a metal oxide with underlying graphene. Such problems are not encountered in the prior art where graphene is transferred since there is no need to consider the stability of the metal oxide coated graphene as a substrate for subsequent graphene growth. The inventors developed the present invention with the aim of overcoming these problems in the prior art.

Thus, in a first aspect, the present invention provides a method of forming a graphene-containing laminate, the method comprising:
providing a first graphene layer structure on a substrate;
forming a first metal oxide layer on the graphene layer structure by depositing and then oxidising a layer of metal;
forming a second metal oxide layer on the first metal oxide layer; and
forming a second graphene layer structure on the second metal oxide layer by CVD.

A second aspect provides a graphene-containing laminate comprising, in order:
a substrate;
a first graphene layer structure;
a first layer of metal oxide, formed by oxidation of a layer of metal;
a second layer of metal oxide; and
a CVD-grown graphene layer structure grown directly on the second metal oxide layer.

The present disclosure will now be described further. In the following passages, different aspects/embodiments of the disclosure are defined in more detail. Each aspect/embodiment so defined may be combined with any other aspect/embodiment or aspects/embodiments unless clearly indicated to the contrary. In particular, any feature indicated as being preferred or advantageous may be combined with any other feature or features indicated as being preferred or advantageous. It is intended that the features disclosed in relation to the method may be combined with those disclosed in relation to the graphene-containing laminate vice versa. Accordingly, the graphene-containing laminate is obtainable by the method and also the method is one of manufacturing the graphene-containing laminate described herein.

The present invention relates to a method of forming a graphene-containing laminate. As described in greater detail herein, the graphene-containing laminate comprises a substrate having thereon, a layer of metal oxide(s) that is sandwiched between first and second graphene layer structures. As such, there are no intervening layers between any given layer said to be "on" another layer.

Forming may be considered synonymous with synthesising, manufacturing, producing and growing. Graphene is a very well-known two-dimensional material referring to an allotrope of carbon comprising a single layer of carbon atoms in a hexagonal lattice. Graphene, as used herein, refers to one or more layers of graphene. Accordingly, the present invention relates to the formation of a monolayer of graphene as well as multilayer graphene. Graphene, as used herein, refers to a graphene layer structure, preferably having from 1 to 10 monolayers of graphene. In many subsequent applications of a graphene-containing laminate, one monolayer of graphene is particularly preferred for one or more of the graphene layer structures present in the laminate. Accordingly, a graphene layer structure is preferably a graphene monolayer. Nevertheless, multilayer graphene may be preferable for certain applications in which case 2 or 3 layers of graphene may be preferred. As described herein, the method of forming the second graphene layer structure comprises forming graphene by CVD directly onto the second metal oxide.

The first graphene layer structure is provided on a substrate, preferably a non-metallic surface. Preferably, the surface is an electrically insulative surface (for example, a substrate may be a silicon substrate having a silicon dioxide surface). The substrate may also be a CMOS wafer which may be silicon based and have associated circuitry embedded within the substrate. A substrate may also comprise one or more layers (for example, regions or channels of embedded waveguide materials such as silicon nitride suitable for EOMs). In another example, a substrate may comprise a non-metallic layer which provides a non-metallic growth surface, and a conductive layer (for example, silicon on insulator (SOI) substrates such as a silicon substrate having a silicon oxide layer). The conductive layer can serve as a contact for electronic devices.

Preferably, the non-metallic surface upon which the graphene layer structure is provided is silicon (Si), silicon carbide (SiC), silicon nitride (Si₃N₄), silicon dioxide (SiO₂), sapphire (Al₂O₃), aluminium gallium oxide (AGO), hafnium dioxide (HfO₂), zirconium dioxide (ZrO₂), yttria-stabilised hafnia (YSH), yttria-stabilised zirconia (YSZ), magnesium aluminate (MgAl₂O₄), yttrium orthoaluminate (YAlO₃), strontium titanate (SrTiO₃), cerium oxide (Ce₂O₃), scandium oxide (Sc₂O₃), erbium oxide (Er₂O₃), magnesium difluoride (MgF₂), calcium difluoride (CaF₂), strontium difluoride (SrF₂), barium difluoride (BaF₂), scandium trifluoride (ScF₃), germanium (Ge), hexagonal boron nitride (h-BN), cubic boron nitride (c-BN) and/or a III/V semiconductor such as aluminium nitride (AIN) and gallium nitride (GaN). Preferably, the substrate comprises silicon, silicon nitride, silicon dioxide, sapphire, aluminium nitride, YSZ, germanium and/or calcium difluoride. In some embodiments, the substrate may consist of one such material.

The method comprises forming a first metal oxide layer on the graphene layer structure by depositing and then oxidising a layer of metal. In the art, this may also be known as a seed layer. Metal may be deposited by any means known in the art, for example using PVD techniques such as sputtering and evaporation.

The metal layer is then oxidised to form a first layer of metal oxide. Such oxidation may occur under ambient conditions in air due to the thinness of the layer (such as when transferring the intermediate substrate from the PVD chamber to an ALD chamber), especially for aluminium, though it is also preferred that this intermediate substrate is heated on a hot-plate (generally up to about 250°C), and preferably in the presence of oxygen gas, in order to accelerate oxidation. As such, this step is distinct from any heating in a chamber for the deposition of the second metal oxide, such as an ALD chamber. A hot-plate is a conventional apparatus which has a flat heated surface upon which the exposed surface of the substrate can be placed.

Other metals may require heating and/or exposure to oxygen in a concentration greater than ambient air (e.g. greater than 21 vol%), such as a mixture of oxygen and inert gas (e.g. N₂, He or Ar) or substantially pure oxygen gas, in order to ensure complete oxidation of the metal layer. Preferably, the step of oxidising the layer of deposited metal comprises heating the layer of metal under an oxygen-containing environment, preferably under an atmosphere substantially consisting of oxygen. Oxygen-containing refers to oxygen gas containing. Water may be present though preferably the only oxygen source is oxygen gas. Heating may involve heating to a temperature of at least 100°C, preferably at least 150°C. Heating at greater than 250°C is not desirable since this typically damages the underlying graphene (since the additional second metal oxide layer is yet to be formed). The substrate may be held at this temperature for at least 10 seconds, preferably at least 30 seconds. Typically, the process is complete within 1 hour, preferably within 10 minutes and may even be complete within 1 minute.

The method also comprises forming a second metal oxide layer on the first metal oxide layer, which will be appreciated uses a different technique to that used to form the first metal oxide layer, most preferably by Atomic Layer Deposition (ALD). ALD is technique known in the art. It comprises the reaction of at least two precursors in a sequential, self-limiting manner. Repeated cycles to the separate precursors allow the growth of a layer in a conformal manner (i.e. uniform thickness across the entire surface) due to the layer-by-layer growth mechanism. Alumina is a particularly preferred coating material and can be formed by sequential exposure to trimethylaluminium (TMA) and an oxygen source, preferably one or more of water (H₂O), O₂ (e.g. O₂ plasma), and ozone (O₃).

The deposition temperature when forming the second metal oxide ALD layer may be any conventional temperature known in the art. Typically the deposition temperature is from 40°C to 300°C, and the inventors have found that temperatures above 100°C are preferable and afford better quality barrier layers having improved dielectric properties over those grown at lower temperatures. The presence of the first metal oxide layer aids to protect the graphene during such deposition and increase the number of nucleation sites available to initiate ALD growth.

Suitable precursors which provide the required inorganic element, for example aluminium or hafnium atoms for alumina and hafnia, are well-known, commercially available and not particularly limited. Preferably, the second metal oxide layer is formed by ALD using a metal alkyl, metal alkoxide or metal halide as a metal precursor (i.e. metal alkyl is (R)ₙM, metal alkoxide is (RO)ₙM and metal halide is (X)ₙM). Metal halides such as metal chlorides (e.g. AlCl₃ and HfCl₄) may be used. Alternatively, metal amides, metal alkoxides or organometallic precursors may be used. Hafnium precursors include, for example, tetrakis(dimethylamido)hafnium(IV), tetrakis(diethylamido)hafnium(IV), hafnium(IV) tert-butoxide and dimethylbis(cyclopentadienyl)hafnium(IV). Preferably, the barrier layer is alumina and preferably a further precursor for the ALD is a trialkyl aluminium or trialkoxide aluminium, such as trimethylaluminium, tris(dimethylamido)aluminium, aluminium tris(2,2,6,6-tetramethyl-3,5-heptanedionate) or aluminium tris(acetylacetonate).

Graphene is known to be highly sensitive to ambient contamination. So as to ensure sufficient lifetime of electronic devices based on graphene, it is necessary to ensure that the graphene is adequately protected from contamination. Typically, this is achieved through the use of insulative dielectric layers which are already a part of the manufacturing process of devices.

There are various methods for depositing metal oxides such as alumina known in the art of electronic device fabrication. The inventors have found that a number of these methods each have their own drawbacks, specifically where the layer is deposited directly on graphene, due to graphene's sensitivity to processing, together with the conventional drawbacks.

For example, ALD provides an advantageously conformal alumina layer. However, such a method does not allow the layer to be deposited on graphene in a patterned manner. Furthermore, the inventors have found that ALD of alumina directly on graphene is more problematic than other substrate surfaces since graphene is a 2D material with few nucleation sites for initiating ALD growth.

This is a problem, in particular, for graphene grown directly onto a substrate by CVD, since in the absence of a transfer step, the graphene is highly uniform with minimal defects and is devoid of contamination from, for example, transfer polymers, which may otherwise serve as nucleation sites for ALD growth. As a result, the inventors have found that the ALD layer ends up having discontinuities and leaks.

The inventors proceeded to investigate other methods of dielectric layer formation such as evaporation deposition (such as by e-beam evaporation) or sputtering, and metal deposition (such as by thermal evaporation) followed by oxidation of the metal layer. The inventors found that dielectric layers formed by evaporation gave rise to current leakage and is too porous, and the oxidation of a metal layer is too thin to provide a suitable dielectric layer for electronic devices, and nevertheless was also found to leak. One advantage over ALD is that, where patterned directly on graphene, this allows the protective oxide coating to simultaneously act as a mask for graphene etching. The inventors found that when graphene was grown on single layers, growth was defective and/or the underlying graphene was damaged. Without wishing to be bound by theory, the inventors at least found that when forming a second graphene layer structure by CVD, which employs high temperature deposition, carbon "bridges" may form within the dielectric layer electrically connecting the underlying first graphene layer structure to the second graphene layer structure. Such electrically conductive carbon pathways lead to current leakage between the two layers which are detrimental for electronic devices.

Despite each dielectric layer individually not having the desired performance for providing a protective air and moisture barrier coating, the inventors were surprised to find that the combination of a first layer formed by an oxidised metal layer followed by a further metal oxide layer formed by an alternative technique provides sufficient protection and overcomes these problems. In particular, the protection afforded by such a combination was sufficient to allow for the further CVD growth of graphene on the insulative layer (e.g. at temperatures greater than 700°C). Accordingly, even though such dielectric layers and the means for their formation are known to those skilled in the art, the advantageous suitability of the combination to protect an underlying graphene layer structure whilst simultaneously providing a surface for a further graphene layer structure to be formed by CVD is unexpected.

The second metal oxide layer may be formed by chemical deposition techniques such as ALD or plasma-enhanced chemical vapour deposition (PECVD), and/or by physical vapour deposition (PVD) techniques, such as sputtering, evaporation (e.g. thermal and/or e-beam evaporation) and/or molecular beam epitaxy (MBE). Individually, these deposition techniques are well-known to those skilled in the art.

The inventors have found that the first metal oxide layer serves to protect the first graphene layer structure during both the deposition of the second metal oxide layer, and, together with said second metal oxide layer, during the CVD growth of a second graphene layer structure. Moreover, ALD has the unique advantage in that the ALD process benefits from the first metal oxide layer as a nucleation layer which aids formation of the ALD layer with significantly reduced risk of damaging the first graphene layer structure during the steps of oxide layer formation. This in turn also allows higher ALD temperatures to be used which the inventors have found improves the dielectric quality. On the other hand, the first metal oxide layer simply serves as a physical barrier to protect the first graphene layer structure during PVD formation of the second metal oxide layer. Regardless, without wishing to be bound by theory, the inventors believe that specific PVD techniques, in particular sputtering and evaporation, are preferable due to the reduced risk of damaging the graphene during deposition. Techniques such as PECVD are less preferred due to the increased risk arising from the typical reaction conditions required.

The combination of first and second metal oxide layers provide individual properties which the inventors have found, when combined, are suitable for protecting the first graphene layer structure during CVD formation of the second graphene layer structure. ALD is particularly preferred for multiple reasons. Without wishing to be bound by theory, the nucleation provided by the first metal oxide layer facilitates formation of a suitably dense layer which helps to prevent carbon diffusion through pores in the layer. The second metal oxide layer having been formed by a layer-by-layer mechanism typically provides low surface roughness and a generally flatter surface than other techniques allowing for higher quality graphene to be grown by CVD thereon.

It will be appreciated that the stoichiometry of metal to oxygen in a metal oxide may in practice vary, and whilst these materials may be referred to as Al₂O₃ or HfO₂ for example, the exact stoichiometry may vary within normal bounds. ALD is also preferred because, again without wishing to be bound by theory, the inventors believe that ALD results in the formation of a second metal oxide layer with improved stoichiometry (i.e. closer to the ideal stoichiometry, such as Al₂O₃). The improved stoichiometry reduces the number of defects in the metal oxide layer. For example, the reduction in the number of oxygen deficient sites at the surface of the metal oxide layer is believed to reduce the likelihood of carbon atom diffusion to form carbon bridges during the subsequent CVD step and reduce the mechanisms for current leakage between the two graphene layer structures via such defect sites. Therefore, the combination of first metal oxide formed by depositing and then oxidising a layer of metal with a second metal oxide formed by ALD provides a beneficial synergy for CVD growth of graphene.

Preferably, the first and/or second metal oxide layer comprises aluminium oxide, hafnium oxide, yttrium oxide, zirconium oxide, yttria-stabilised zirconia, scandium oxide, cerium oxide, magnesium oxide, silicon oxide, gallium oxide or a mixture of two or more thereof, preferably aluminium oxide, hafnium oxide, yttrium oxide, zirconium oxide, cerium oxide, or a mixture of two or more thereof. The first and second layers are independently selected though they may preferably be the same. The metal oxide layer preferably consists of these materials. For example, the metal oxide layer is nanolaminate thereof. A nanolaminate may be formed by repetitions of metal deposition and oxidation. The inventors have found that these materials are preferred as they are most suitable for CVD. For example, zinc oxide and titanium oxide may be less chemically stable and can undergo phase changes when heated during CVD.

The inventors found that deposition of a metal layer was less damaging to the graphene during deposition. Deposition of an initial metal layer was also found to provide more homogenous doping of the first graphene layer structure. If necessary, an appropriately doped graphene layer structure (e.g. p-doped graphene) can be provided so as to counteract the subsequent n-doping by the metal layer deposited and oxidised thereon.

The layer of metal has to be thin enough to be oxidised and complete oxidation of such a layer can be readily determined by those skilled in the art using conventional techniques. Preferably, the layer of metal has a thickness of less than 10 nm, preferably less than 5 nm. The thickness of metal layer is preferably at least 1 nm, preferably at least 2 nm. Whilst the metal layer preferably has uniform thickness, in some embodiments, the metal layer may be formed of a uniformly distributed plurality of "islands" or "seeds" and thickness of each seed (that is the mean average height of the metal from the first graphene layer structure) is as described above. Preferably the metal layer covers at least 50% of the area of the graphene, preferably at least 75%, more preferably at least 90% and most preferably completely covers the area of graphene. The thickness of the metal layer does not appreciably change upon oxidation such that the thickness of the first metal oxide may be considered the same. It is nevertheless preferred that the metal layer is a uniform layer extending across the entire surface of the first graphene layer structure.

Preferably, the second metal oxide layer has a thickness of at least 5 nm, preferably at least 10 nm, and/or has a thickness of less than 50 nm, preferably less than 30 nm since this is most suited for subsequent use in electronic devices though the layer may have a much greater thickness, typically no more than 1 µm. A thickness of greater than 5 nm is preferred to ensure conformity of the layer. Equally, the preferred total thickness of the metal oxide layer is less than 1 µm, such as from 10 nm to 50 nm. Preferably, a ratio of a thickness of the first metal oxide layer to a thickness of the second metal oxide layer is from 1:1 to 1:10, preferably from 1:2 to 1:5. Thicknesses may be measured using any conventional technique, for example ellipsometry.

Preferably, the first metal oxide layer is formed through a mask to provide a patterned first metal oxide layer on the first graphene layer structure. Preferably, the method further comprises a step of patterning the first graphene layer structure on the substrate after the step of forming the first metal oxide layer and before the step of forming the second metal oxide layer. Patterning may preferably be carried out in combination with patterning of the first metal oxide layer. Preferably, the step of patterning the first graphene layer structure comprises plasma etching, preferably oxygen plasma etching, any exposed portion of the first graphene layer structure. In other words, all exposed portion(s) are etched so as to leave behind only the graphene layer structure directly under the first metal oxide layer which acts as a mask. This is preferred for the production of graphene based electronic devices where the first metal oxide layer serves to both pattern and protect the graphene. In other embodiments, the graphene may simply be patterned by laser etching, for example, or using photolithography.

The graphene-containing laminate of the present invention is preferably obtained by the method described herein. The laminate comprises, or consists of, in order: a substrate, a first graphene layer structure, a first layer of metal oxide, formed by oxidation of a layer of metal, a second layer of metal oxide, a CVD-grown graphene layer structure grown directly on the second metal oxide layer. As described herein, the second layer of metal oxide may be formed by ALD or PVD, preferably ALD.

Such product can be readily identified by those skilled in the art using conventional techniques. For example, the difference is explicit where different metals are used to form the first and second metal oxide layers. However, even where the same metal is used, for example through deposition of an aluminium layer, oxidation of said layer and deposition of an alumina layer by ALD for example, the different methods result in layers of inevitably different properties that distinguish them. Typically, an ALD grown layer has a greater density and/or the layers may have different crystal structures. The ALD layer is also typically associated with a greater level of elemental impurities due to the use of volatile organometallic precursors (e.g. carbon, nitrogen and/or hydroxyl impurities). These may be identified using techniques such as Energy-dispersive X-ray spectroscopy (EDX) and X-Ray Photoelectron Spectroscopy (XPS). The interface of the two layers arising from the discontinuous growth method has also been observed to serve as a trap for such impurities leading to a noticeable boundary between said layers. Furthermore, cross sectional Transmission Electron Microscopy (TEM) can also be used to identify the presence of two distinct layers since each layer will present a contrast rather than a uniform metal oxide layer in view of the foregoing differences.

Preferably, as a result of the method, the second layer of metal oxide has a root mean square surface roughness (Rq) of less than 5 nm, preferably less than 3 nm or less than 2 nm, as may the second graphene layer structure thereon have such an Rq.

CVD refers generally to a range of chemical vapour deposition techniques, each of which involve vacuum deposition to produce thin film materials such as two-dimensional crystalline materials like graphene. Volatile precursors, those in the gas phase or suspended in a gas, are decomposed to liberate the necessary species to form the desired material, carbon in the case of graphene.

CVD as described herein is intended to refer to thermal CVD such that the formation of graphene from the decomposition of a carbon-containing precursor is the result of the thermal decomposition of said carbon-containing precursor.

The graphene being grown by CVD directly on the metal oxide therefore avoids physical transfer processing. The physical transfer of graphene, usually from copper substrates, introduces numerous defects which negatively impacts the physical and electronic properties of graphene. As such, a person skilled in the art can readily ascertain whether a graphene layer structure, and by extension a graphene-containing laminate is one comprising a CVD-grown graphene layer structure that has been grown directly on the specific materials using conventional techniques in the art such as atomic force microscopy (AFM) and energy dispersive X-ray (EDX) spectroscopy. The graphene layer structure is devoid of copper contamination and devoid of transfer polymer residues by virtue of the complete absence of these materials in the process of obtaining the graphene substrate. Furthermore, such processing is not suitable for large scale manufacture (such as on CMOS substrates in fabrication plants). Unintentional doping, particularly from the catalytic metal substrates together with the etching solutions, also results in the production of graphene which is not sufficiently consistent from sample to sample as is required for commercial production.

As will be appreciated, the graphene is formed on a surface of a substrate which may be referred to as a growth surface of a growth substrate. The discussion herein with respect to CVD applies equally to the formation of the first graphene layer on a substrate as it does to the formation of a second graphene layer on a substrate (though the substrate upon which the second graphene layer structure is formed in one which is formed of the first substrate, the first graphene layer structure and the first and second metal oxide layers). Indeed, the process may comprise repeating both steps of forming a first and second metal oxide layer on the second graphene layer structure. These steps are repeated in the same order of a further first metal oxide layer followed by a further second metal oxide layer on the further first metal oxide layer, and preferably a further graphene layer structure is formed thereon by CVD. Alternatively, the further metal oxide layer may serve as a final coating. The method may be repeated to form a graphene-containing laminate comprising several graphene and insulative dielectric layers.

Preferably, the method involves forming graphene by thermal CVD such that decomposition is a result of heating the carbon-containing precursor. Preferably, the temperature of the growth surface during CVD is from 700°C to 1350°C, preferably from 800°C to 1250°C, more preferably from 1000°C to 1250°C. The inventors have found that such temperatures are effective for providing graphene growth directly on the materials described herein by CVD. More importantly, the inventors were surprised to find that the combination of two metal oxide layers formed by the method described herein provides sufficient stability to allow for CVD growth of graphene thereon whilst protecting the underlying graphene layer structure on the substrate.

Preferably, the CVD reaction chamber used in the method disclosed herein is a cold-walled reaction chamber wherein a heater coupled to the substrate is the only source of heat to the chamber. In a particularly preferred embodiment, the CVD reaction chamber comprises a close-coupled showerhead having a plurality, or an array, of precursor entry points. Such CVD apparatus comprising a close-coupled showerhead may be known for use in MOCVD processes. Accordingly, the method may alternatively be said to be performed using an MOCVD reactor comprising a close-coupled showerhead. In either case, the showerhead is preferably configured to provide a minimum separation of less than 100 mm, more preferably less than 25 mm, even more preferably less than 10 mm, between the surface of the substrate and the plurality of precursor entry points. As will be appreciated, by a constant separation it is meant that the minimum separation between the surface of the substrate and each precursor entry point is substantially the same. The minimum separation refers to the smallest separation between a precursor entry point and the substrate surface (i.e. the surface of the metal oxide layer). Accordingly, such an embodiment involves a "vertical" arrangement whereby the plane containing the precursor entry points is substantially parallel to the plane of the substrate surface (i.e. the growth surface).

The precursor entry points into the reaction chamber are preferably cooled. The inlets, or when used, the showerhead, are preferably actively cooled by an external coolant, for example water, so as to maintain a relatively cool temperature of the precursor entry points such that the temperature of the precursor as it passes through the plurality of precursor entry points and into the reaction chamber is less than 100°C, preferably less than 50°C. For the avoidance of doubt, the addition of precursor at a temperature above ambient does not constitute heating the chamber, since it would be a drain on the temperature in the chamber and is responsible in part for establishing a temperature gradient in the chamber.

Preferably, a combination of a sufficiently small separation between the substrate surface and the plurality of precursor entry points and the cooling of the precursor entry points, coupled with the heating of the substrate to with a decomposition range of the precursor, generates a sufficiently steep thermal gradient extending from the substrate surface to the precursor entry points to allow graphene formation on the substrate surface. As disclosed in WO 2017/029470, very steep thermal gradients may be used to facilitate the formation of high-quality and uniform graphene directly on non-metallic substrates, preferably across the entire surface of the substrate. The substrate may have a diameter of at least 5 cm (2 inches), at least 15 cm (6 inches) or at least 30 cm (12 inches). Particularly suitable apparatus for the method described herein include an Aixtron^{®} Close-Coupled Showerhead^{®} reactor and a Veeco^{®} TurboDisk reactor.

Consequently, in a particularly preferred embodiment wherein the method of the present invention involves using a method as disclosed in WO 2017/029470, forming the graphene layer structure on the growth surface by CVD comprises:
providing the growth substrate on a heated susceptor in a close-coupled reaction chamber, the close-coupled reaction chamber having a plurality of cooled inlets arranged so that, in use, the inlets are distributed across the growth surface and have constant separation from the substrate;
cooling the inlets to less than 100°C (i.e. so as to ensure that the precursor is cool as it enters the reaction chamber);
introducing a carbon-containing precursor in a gas phase and/or suspended in a gas through the inlets and into the close-coupled reaction chamber; and
heating the susceptor to achieve a growth surface temperature of at least 50°C in excess of a decomposition temperature of the precursor, to provide a thermal gradient between the substrate surface and inlets that is sufficiently steep to allow the formation of graphene from carbon released from the decomposed precursor;
wherein the constant separation is less than 100 mm, preferably less than 25 mm, even more preferably less than 10 mm.

The most common carbon-containing precursor in the art for graphene growth is methane (CH₄). Particularly preferred organic compounds for use as carbon-containing precursors are hydrocarbons, and methods of forming graphene therefrom by CVD, are described in UK Patent Application No. 2103041.6, the contents of which is incorporated herein in its entirety.

Preferably, the first graphene layer structure is also formed by CVD which is formed directly on the substrate. With the present method addressing the problems with forming a dielectric layer on the first graphene layer structure, CVD grown graphene is preferred due to its uniformity and, without wishing to be bound by theory, leads to a smoother dielectric layer thereon which therefore provides a smoother surface for the growth of the second graphene layer structure.

The present invention therefore also provides a use of a metal oxide layer formed by depositing and then oxidising a layer of metal on a first graphene layer structure for protecting said graphene layer structure during the CVD deposition of a second graphene layer structure on a surface thereof. That is, a surface of the formed metal oxide layer opposite the surface that is in contact with the first graphene layer structure. The purpose of a metal oxide layer formed by such a method is to protect the underlying graphene from degradation during further processing at temperatures is excess of 700°C.

In a further aspect of the present invention, there is provided an electronic device comprising the graphene-containing laminate described herein. That is, an electronic device may be formed using the method disclosed herein, or the resulting graphene-containing laminate, using conventional techniques to pattern and etch the layers as desired and to deposit contacts for connection into an electronic circuit (such as via metal wires). As will be appreciated, a large-area graphene-containing laminate (i.e. a wafer such as one having a diameter of greater than or equal to 5 cm (2 inches)) may be processed to manufacture an array of electronic devices on the common underlying substrate. This may then be diced into individual devices such that an electronic device comprises a portion of a larger graphene-containing laminate.

Typically, contacts are metal contacts, such as those formed of chromium, titanium, aluminium, nickel and/or gold. Generally contacts are provided in contact with each of the first and second (and any further) graphene layer structures of the graphene-containing laminate. These may have an edge and/or surface contact with each graphene layer structure.

The architecture provided by the laminated structure of graphene, dielectric metal oxide and graphene is particularly suitable for incorporation into electro-optic devices through appropriate further processing but may also be used in other devices such as transistors, capacitors and diodes (including LEDs and solar cells as well as resonant tunnelling diodes).

### Figures

The present invention will now be described further with reference to the following non-limiting Figures, in which:
Figure 1 illustrates a comparative method comprising deposition of a first metal oxide layer by evaporation and a second metal oxide layer thereon by ALD.
Figure 2 illustrates a comparative method comprising deposition of a metal oxide layer by ALD which comprises a nucleation step.
Figure 3 illustrates a comparative method comprising deposition of a metal oxide layer by deposition and oxidation of a layer of metal.
Figure 4 illustrates a method according to the present invention comprising deposition of a first metal oxide layer by deposition and oxidation of a layer of metal followed by deposition of a second metal oxide layer thereon by ALD to form a graphene-containing laminate.
Figure 5 is a cross-section of an electro-optic modulator comprising a graphene-containing laminate.
Figure 6A is an AFM image of graphene grown on a c-plane sapphire substrate. Figure 6B is the corresponding Raman spectrum.
Figure 7A is an AFM image of aluminium metal deposited on the graphene shown in Figure 6. Figure 7B is the corresponding Raman spectrum.
Figure 8A is an AFM image of alumina grown by ALD on the aluminium shown in Figure 7 after oxidation on a hotplate. Figure 8B is the corresponding Raman spectrum.
Figure 9A is an AFM image of a second graphene grown on the ALD alumina layer shown in Figure 8. Figure 9B is the corresponding Raman spectrum.

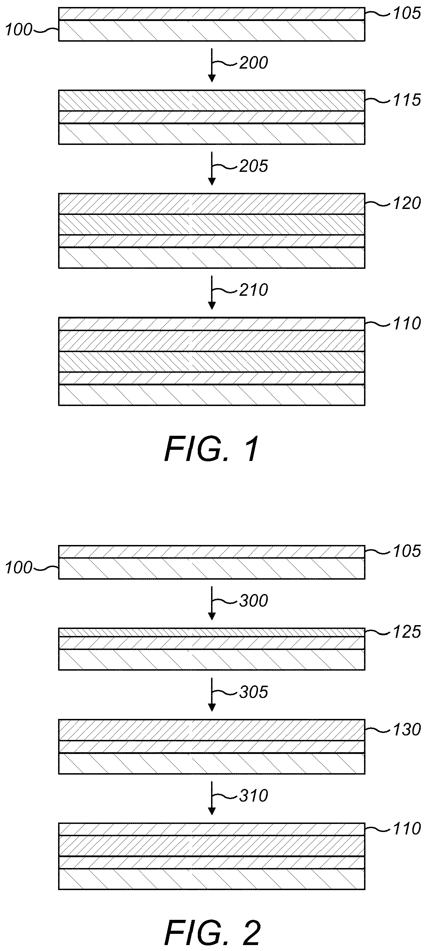

Figure 1 illustrates, in cross-section, a first comparative method starting with a non-metallic substrate 100, such as sapphire, having a first graphene layer structure 105 thereon. The first graphene layer structure 105 may have been grown directly on the substrate 100 by CVD, though it is conventional in the art that the graphene layer structure 105 is first grown on a catalytic metal substrate, such as copper or nickel, and then transferred to the non-metallic substrate 100.

A first layer of metal oxide 115, for example alumina, is deposited by e-beam evaporation 200 of alumina onto the exposed surface of the first graphene layer structure 105. A second layer of metal oxide 120, for example further alumina, is deposited by atomic layer deposition (ALD) 205 through sequential addition of an organoaluminium and an oxygen source, such as trimethylaluminium and water. A second graphene layer structure 110 is then grown by CVD 210 on the exposed surface of the ALD alumina layer 120, at a temperature of greater than 700°C.

The inventors found that even where the first graphene layer structure 105 is grown by CVD on the substrate 100, the resulting stack of alumina layers 115, 120 did not sufficiently protect the first graphene layer structure 105 during the high temperature CVD 210.

Figure 2 illustrates, in cross-section, a second comparative method starting with the same first graphene layer structure 105 on a non-metallic substrate 100 as that shown in Figure 1. The method shown in Figure 2 comprises formation of a nucleation layer 125 by treatment 300 of the surface of the first graphene layer structure 105 with ozone at a relatively low temperature, such as less than 100°C. Treatment 300 introduces a number of defects on the surface of the first graphene layer structure 105 which serve to nucleate growth of alumina by ALD 305, equivalent to step 205 shown in Figure 1. As such, the nucleation layer 125 is incorporated into the ALD alumina layer 130. The thickness of the alumina layer may be 20 nm, for example.

A second graphene layer structure 110 is then grown by CVD 310 on the exposed surface of the ALD alumina layer 130, at a temperature of greater than 700°C, equivalent to step 210 shown in Figure 1. The inventors again found that the metal oxide layer 130 did not sufficiently protect the first graphene layer structure 105. In particular, the inventors found that the high temperature can cause the alumina 130 to crack and split along wrinkle lines of the underlying first graphene layer structure 105. As a result, the second graphene layer structure 110 grown on the alumina 130 was itself highly defective.

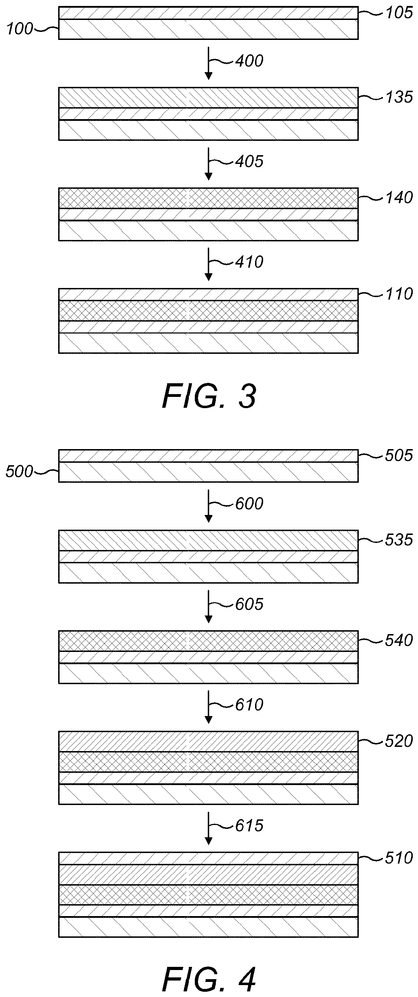

Figure 3 illustrates, in cross-section, a third comparative method starting with the same first graphene layer structure 105 on a non-metallic substrate 100 as that shown in Figure 1. The method shown in Figure 3 comprises deposition of a 5 nm layer of aluminium metal 135 by thermal evaporation 400 onto the exposed surface of the first graphene layer structure 105. The aluminium metal layer 135 is allowed to auto-oxidise 405 upon exposure to ambient air to form an alumina layer 140 of substantially the same thickness. Oxidation of the aluminium layer 135 to an alumina layer 140 may be accelerated by placing the exposed surface of the substrate 100 onto a conventional hot-plate and heating to a temperature of, for example, about 150°C. Complete oxidation may be readily ascertained by XPS. The inventors found that deposition of aluminium metal was less damaging to the first graphene layer structure 105, though thermal oxidation of the metal was found through conventional Raman spectroscopy measurements to damage the first graphene layer structure 105.

The inventors investigated the growth of a second graphene layer structure 110 by CVD 410 on the exposed surface of the alumina layer 140, at a temperature of greater than 700°C, equivalent to step 210 shown in Figure 1. In this case, the inventors again were surprised to find that typical conditions for graphene growth of a second graphene layer structure 110 instead restored some of the integrity of the underlying first graphene layer structure 105 rather than lead to the formation of a second graphene layer structure 110. As such, the inventors found that the alumina 140 alone is unsuitable for the formation of a graphene-containing laminate using CVD.

Figure 4 illustrates, in cross-section, a method according to the present invention for forming a graphene-containing laminate starting with an equivalent first graphene layer structure 505 on a non-metallic substrate 500 as that shown in Figure 1. It is particularly preferred that the first graphene layer structure 505 is formed directly on the non-metallic substrate by CVD. The method shown in Figure 4 comprises depositing a metal such as aluminium by thermal evaporation 600 to form a metal layer 535 on the exposed surface of the first graphene layer structure 505. The metal layer 535 is allowed to auto-oxidise 605 upon exposure to an atmosphere of pure oxygen gas to form a first layer of metal oxide 540, such as alumina. The metal layer 535 has a thickness of from 1 nm to 5 nm, as does the metal oxide layer 540 have substantially the same thickness as a result.

A second layer of metal oxide 520, for example further alumina, is deposited by ALD 610 through sequential addition of trimethylaluminium and water. The sequential steps are repeated until the second layer of metal oxide 520 formed on the first layer of metal oxide 540 has a thickness of from 10 nm to 50 nm, and as such a ratio of a thickness of the first metal oxide layer 540 to a thickness of the second metal oxide layer 520 is at least 1:2. A second graphene layer structure 510 is then grown by CVD 615 on the exposed surface of the ALD layer 520, at a temperature of greater than 700°C, preferably greater than 1000°C. The first and second metal oxide layers 540, 520 in combination are sufficiently robust so as to protect the underlying first graphene layer structure 505 during the high temperature formation of the second graphene layer structure 510 by CVD, the two graphene layer structures 505, 510 being electrically isolated from one another.

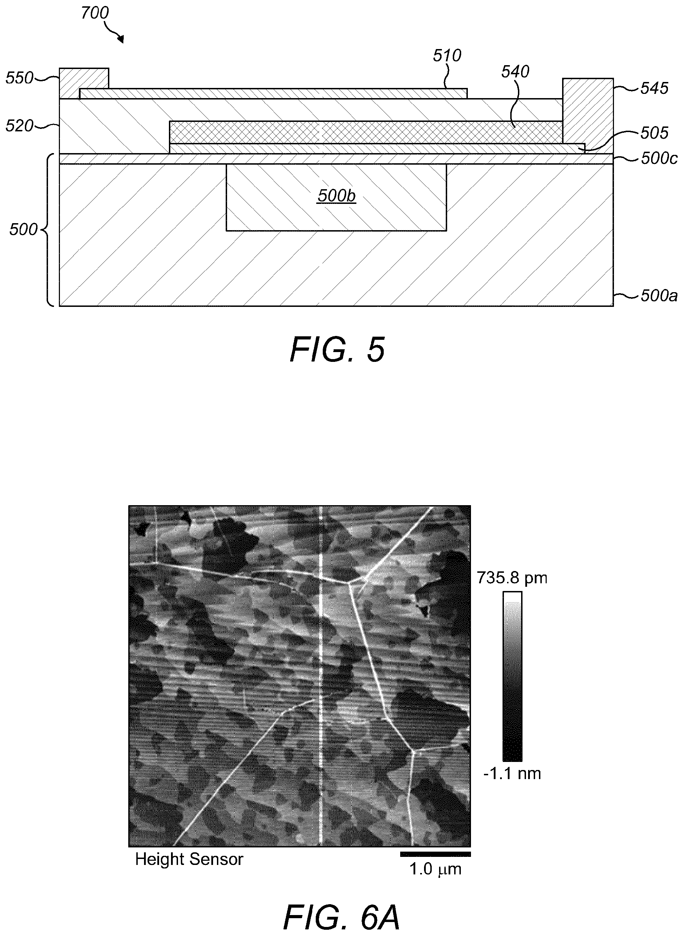

Figure 5 shows a cross-section of an electro-optic modulator (EOM) 700 comprising a graphene-containing laminate of the present invention. The EOM 700 may be part of an array of EOMs formed on a common substrate that may be diced to provide the individual devices. EOM 700 comprises a substrate 500 that comprises a silicon dioxide cladding 500a and an embedded rectangular silicon nitride waveguide 500b, the waveguide 500b and cladding 550a sharing a uniform and substantially flat upper surface. Optionally, the substrate may comprise a further layer 500c across the upper surface which may then serve to provide a growth surface for the formation of a first graphene layer structure 505 thereon by CVD. In one embodiment, the further layer is a layer of silicon nitride which may have been deposited by PECVD, for example, when forming the waveguide 500b.

EOM 700 comprises a patterned first graphene layer structure 505 on the silicon nitride layer 500c and has a first layer of metal oxide 540 thereon, the metal oxide 540 having been formed by depositing and then oxidising a layer of metal. A second metal oxide layer 520 having been formed by ALD is provided on the first layer of metal oxide 520, at least in a region directly above the waveguide 500b. EOM 700 further comprises a second graphene layer structure 510 on the ALD metal oxide 520 that has been patterned so as to overlay a region of both the waveguide 500b and the patterned first graphene layer structure 505. There are also provided metal contacts 545, 550. The first metal contact 545 is in electrical contact with the edge and an adjacent surface of the first graphene layer structure 505 and the second metal contact 550 is in electrical contact with the edge and an adjacent surface of the second graphene layer structure 510. These metal contacts may be connected to an electronic circuit by any suitable means such as wire bonding.

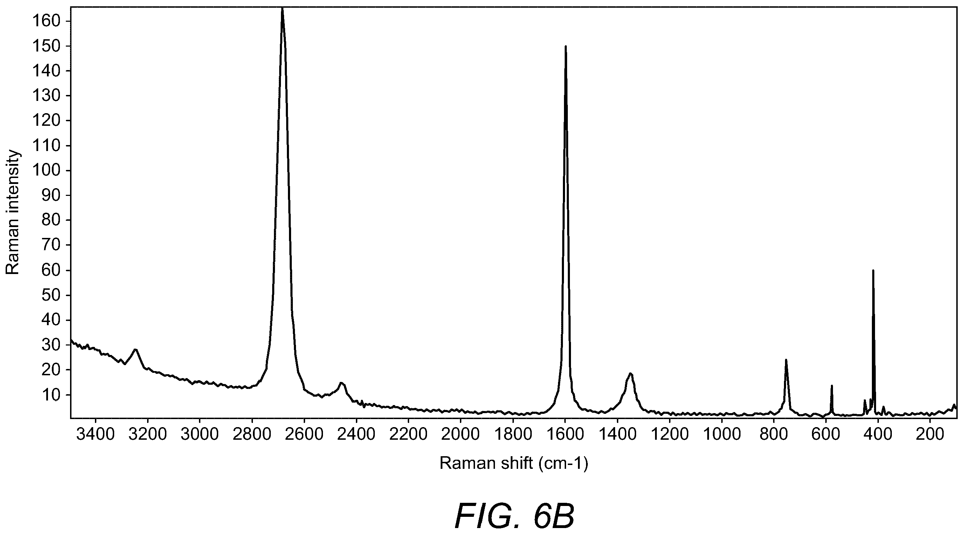

Figures 6A to 9B provide experimental data demonstrating the method of the present invention. Figure 6A is an AFM image of graphene grown directly on a c-plane surface of a sapphire substrate by CVD. Figure 6B is the corresponding Raman spectrum clearly showing a left-hand 2D peak at around 2700 cm⁻¹ and a right-hand G peak at around 1600 cm⁻¹.

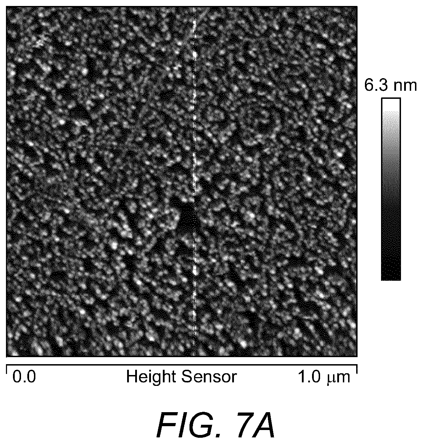

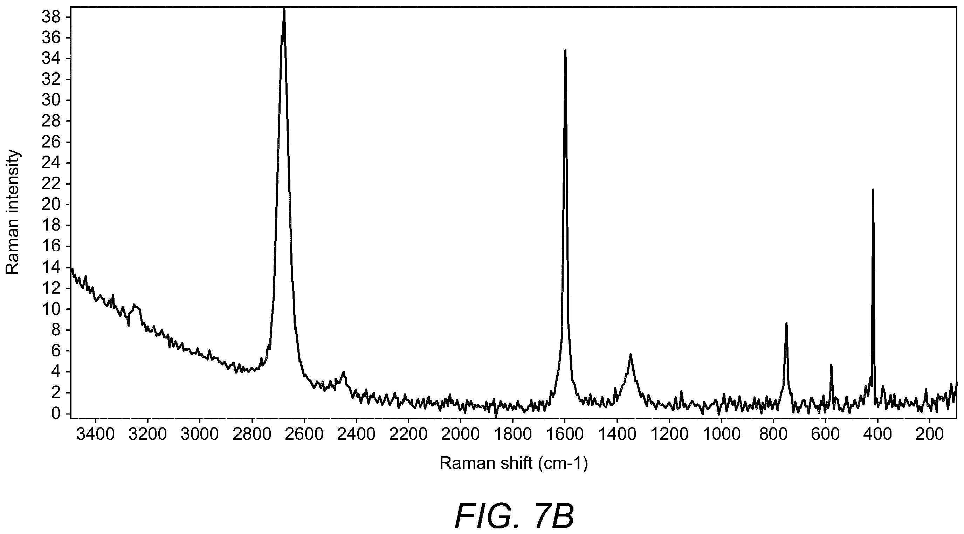

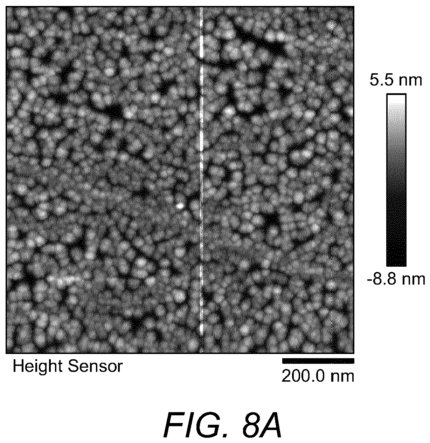

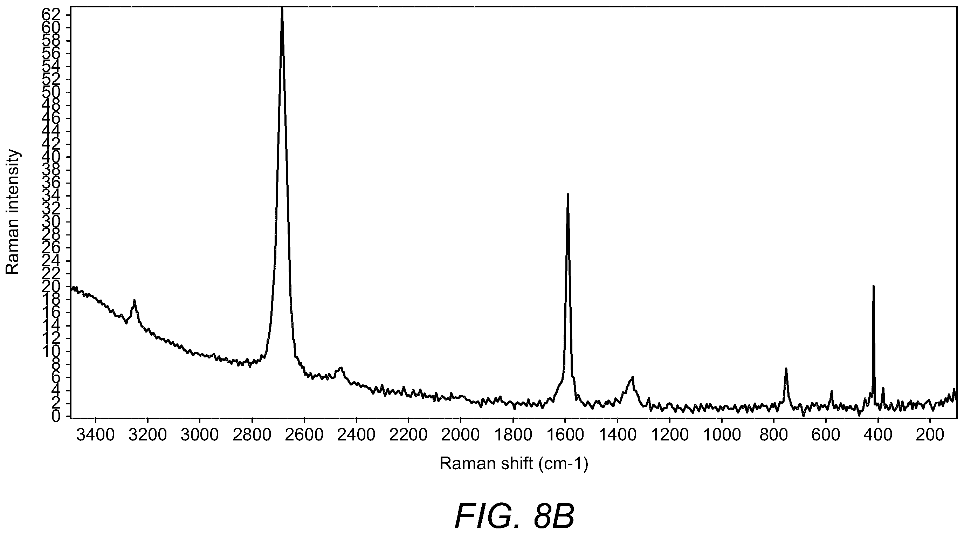

Figure 7A is an AFM image of aluminium metal deposited on the graphene shown in Figure 6. Figure 7B is the corresponding Raman spectrum demonstrating minimal damage to the underlying graphene. Figure 8A is an AFM image of alumina grown by ALD on the aluminium shown in Figure 7 after oxidation on a hotplate. Figure 8B is the corresponding Raman spectrum which again shows minimal damage to the underlying graphene. The alumina grown by ALD provides large, flat and aligned grains which are suitable for growth of a second graphene layer by CVD thereon.

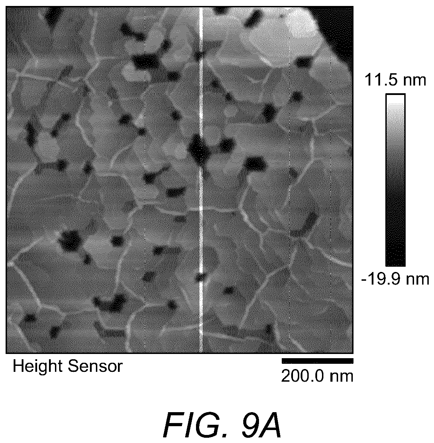

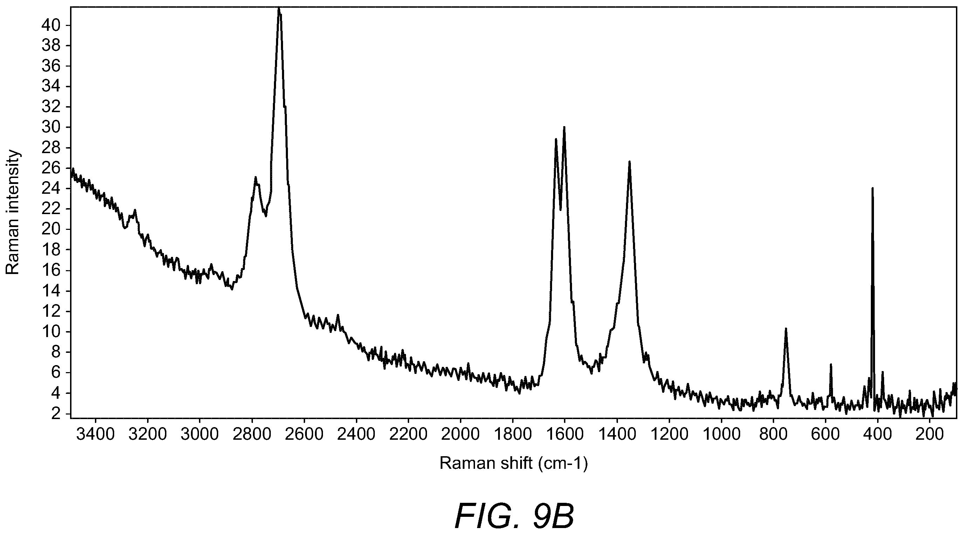

Figure 9A is an AFM image of a second graphene grown on the ALD alumina layer shown in Figure 8. Figure 9B is the corresponding Raman spectrum and clearly demonstrates that growth of a second graphene layer structure is successful due to "splitting" of the 2D and G peaks in the Raman spectrum where each of the first and second graphene produce peaks at slightly varying wavenumbers.

### Examples

Graphene was grown directly on a 2 inch (50 mm) diameter sapphire substrate in an MOCVD reactor, according to the process in WO2017/029470.

1 nm of aluminium was deposited by electron beam deposition in an evaporation deposition system to form a metal layer on the surface of the graphene.

The aluminium was oxidised by heating on a hotplate at 160°C for a minimum of 10 minutes in air.

A layer of Al₂O₃ is then formed by ALD by pulsing trimethyl aluminium as the metalorganic precursor and H₂O as the co-reactant in a sequential manner at 150°C until a thickness of 20 nm was achieved.

As used herein, the singular form of "a", "an" and "the" include plural references unless the context clearly dictates otherwise. The use of the term "comprising" is intended to be interpreted as including such features but not excluding other features and is also intended to include the option of the features necessarily being limited to those described. In other words, the term also includes the limitations of "consisting essentially of" (intended to mean that specific further components can be present provided they do not materially affect the essential characteristic of the described feature) and "consisting of" (intended to mean that no other feature may be included such that if the components were expressed as percentages by their proportions, these would add up to 100%, whilst accounting for any unavoidable impurities), unless the context clearly dictates otherwise.

It will be understood that, although the terms "first", "second", etc. may be used herein to describe various elements, layers and/or portions, the elements, layers and/or portions should not be limited by these terms. These terms are only used to distinguish one element, layer or portion from another, or a further, element, layer or portion. It will be understood that the term "on" is intended to mean "directly on" such that there are no intervening layers between one material being said to be "on" another material. Spatially relative terms, such as "under", "below", "beneath", "lower", "over", "above", "upper" and the like, may be used herein for ease of description to describe one element or feature's relationship to another element(s) or feature(s). It will be understood that the spatially relative terms are intended to encompass different orientations of the graphene-containing laminate in use or operation in addition to the orientation depicted in the figures. For example, if the laminate as described herein is turned over, elements described as "under" or "below" other elements or features would then be oriented "over" or "above" the other elements or features. Thus, the example term "under" can encompass both an orientation of over and under. The laminate may be otherwise oriented and the spatially relative descriptors used herein interpreted accordingly.

The foregoing detailed description has been provided by way of explanation and illustration, and is not intended to limit the scope of the appended claims. Many variations of the presently preferred embodiments illustrated herein will be apparent to one of ordinary skill in the art, and remain within the scope of the appended claims.

## Claims

1. A method of forming a graphene-containing laminate, the method comprising:
providing a first graphene layer structure on a substrate;
forming a first metal oxide layer on the graphene layer structure by depositing and then oxidising a layer of metal;
forming a second metal oxide layer on the first metal oxide layer; and
forming a second graphene layer structure on the second metal oxide layer by CVD.

2. The method according to claim 1, wherein the second metal oxide layer is formed by atomic layer deposition (ALD) or physical vapour deposition (PVD), preferably by **ALD** using water as an oxygen precursor and/or using a metal alkyl, metal alkoxide or metal halide as a metal precursor.

3. The method according to any preceding claim, wherein the first graphene layer structure is formed by CVD.

4. The method according to any preceding claim, wherein both steps of forming a first and second metal oxide layer are repeated on the second graphene layer structure.

5. The method according to any preceding claim, wherein the first and/or second metal oxide layer comprises aluminium oxide, hafnium oxide, yttrium oxide, zirconium oxide, yttria-stabilised zirconia, scandium oxide, cerium oxide, magnesium oxide, silicon oxide, gallium oxide or a mixture of two or more thereof, preferably aluminium oxide, hafnium oxide, yttrium oxide, zirconium oxide, cerium oxide, or a mixture of two or more thereof.

6. The method according to any preceding claim, wherein the step of oxidising the layer of deposited metal comprises heating the layer of metal under an oxygen-containing environment, preferably under an atmosphere substantially consisting of oxygen.

7. The method according to any preceding claim, wherein the step of oxidising the layer of deposited metal comprises heating the layer of metal over a hot-plate.

8. The method according to any preceding claim, wherein the metal is aluminium or hafnium, preferably aluminium, and/or wherein the layer of metal has a thickness of less than 10 nm, preferably less than 5 nm.

9. The method according to any preceding claim, wherein the second metal oxide layer has a thickness of at least 5 nm, preferably at least 10 nm, and/or has a thickness of less than 50 nm, preferably less than 30 nm, and/or wherein a ratio of a thickness of the first metal oxide layer to a thickness of the second metal oxide layer is from 1:1 to 1:10, preferably from 1:2 to 1:5.

10. The method according to any preceding claim, wherein the first metal oxide layer is formed through a mask to provide a patterned first metal oxide layer on the first graphene layer structure.

11. The method according to any preceding claim, further comprising a step of patterning the first graphene layer structure on the substrate after the step of forming the first metal oxide layer and before the step of forming the second metal oxide layer, preferably wherein the step of patterning the first graphene layer structure comprises plasma etching any exposed portion of the first graphene layer structure.

12. A graphene-containing laminate comprising, in order:
a substrate;
a first graphene layer structure;
a first layer of metal oxide, formed by oxidation of a layer of metal;
a second layer of metal oxide; and
a CVD-grown graphene layer structure grown directly on the second metal oxide layer.

13. The graphene-containing laminate according to claim 12, wherein the second layer of metal oxide is formed by ALD or PVD, preferably ALD.

14. The graphene-containing laminate according to claim 12 or claim 13, wherein the first graphene layer structure is grown by CVD directly on the substrate.

15. An electronic device comprising the graphene-containing laminate of any of claims 12 to 14.

## Patentansprüche

1. Verfahren zum Bilden eines graphenhaltigen Laminats, wobei das Verfahren umfasst:
Bereitstellen einer ersten Graphenschichtstruktur auf einem Substrat;
Bilden einer ersten Metalloxidschicht auf der Graphenschichtstruktur durch Abscheiden und danach Oxidieren einer Schicht aus Metall;
Bilden einer zweiten Metalloxidschicht auf der ersten Metalloxidschicht; und
Bilden einer zweiten Graphenschichtstruktur auf der zweiten Metalloxidschicht durch CVD.

2. Verfahren nach Anspruch 1, wobei die zweite Metalloxidschicht durch Atomschichtabsetzung (ALD) oder physikalische Dampfabscheidung (PVD), vorzugsweise durch ALD unter Verwendung von Wasser als Sauerstoffvorläufer und/oder unter Verwendung eines Metallalkyls, Metallalkoxids oder Metallhalogenids als Metallvorstufe gebildet wird.

3. Verfahren nach einem vorstehenden Anspruch, wobei die erste Graphenschichtstruktur durch CVD gebildet wird.

4. Verfahren nach einem vorstehenden Anspruch, wobei beide Schritte zum Bilden einer ersten und zweiten Metalloxidschicht auf der zweiten Graphenschichtstruktur wiederholt werden.

5. Verfahren nach einem vorstehenden Anspruch, wobei die erste und/oder zweite Metalloxidschicht Aluminiumoxid, Hafniumoxid, Yttriumoxid, Zirkoniumoxid, mit Yttrium stabilisiertes Zirkoniumdioxid, Scandiumoxid, Ceroxid, Magnesiumoxid, Siliciumoxid, Galliumoxid oder ein Gemisch aus zwei oder mehr davon, vorzugsweise Aluminiumoxid, Hafniumoxid, Yttriumoxid, Zirkoniumoxid, Ceroxid oder einem Gemisch aus zwei oder mehr davon umfasst.

6. Verfahren nach einem vorstehenden Anspruch, wobei der Schritt zum Oxidieren des abgeschiedenen Metalls Erhitzen der Metallschicht unter einer sauerstoffhaltigen Umgebung, vorzugsweise unter einer im Wesentlichen aus Sauerstoff bestehenden Atmosphäre, umfasst.

7. Verfahren nach einem vorstehenden Anspruch, wobei der Schritt zum Oxidieren der Schicht aus abgeschiedenem Metall Erhitzen der Metallschicht über einer Heizplatte umfasst.

8. Verfahren nach einem vorstehenden Anspruch, wobei das Metall Aluminium oder Hafnium, vorzugsweise Aluminium, ist und/oder wobei die Metallschicht eine Dicke von weniger als 10 nm, vorzugsweise weniger als 5 nm aufweist.

9. Verfahren nach einem vorstehenden Anspruch, wobei die zweite Metalloxidschicht eine Dicke von mindestens 5 nm, vorzugsweise mindestens 10 nm, aufweist, und/oder eine Dicke von weniger als 50 nm, vorzugsweise weniger als 30 nm aufweist, und/oder wobei ein Verhältnis einer Dicke der ersten Metalloxidschicht zu einer Dicke der zweiten Metalloxidschicht von 1:1 bis 1:10, vorzugsweise von 1:2 bis 1:5 beträgt.

10. Verfahren nach einem vorstehenden Anspruch, wobei die erste Metalloxidschicht durch eine Maske gebildet wird, um eine gemusterte erste Metalloxidschicht auf der ersten Graphenschichtstruktur bereitzustellen.

11. Verfahren nach einem vorstehenden Anspruch, weiter umfassend einen Schritt zum Mustern der ersten Graphenschichtstruktur auf dem Substrat nach dem Schritt zum Bilden der ersten Metalloxidschicht und vor dem Schritt zum Bilden der zweiten Metalloxidschicht, wobei der Schritt zum Mustern der ersten Graphenschichtstruktur vorzugsweise Plasma-Ätzen eines freiliegenden Abschnitts der ersten Graphenschichtstruktur umfasst.

12. Graphenhaltiges Laminat, in der Reihenfolge umfassend:
ein Substrat;
eine erste Graphenschichtstruktur;
eine erste Schicht aus Metalloxid, die durch Oxidieren einer Metallschicht gebildet wird;
eine zweite Schicht aus Metalloxid; und
eine mittels CVD gewachsene Graphenschichtstruktur, die direkt auf der zweiten Metalloxidschicht gewachsen ist.

13. Graphenhaltiges Laminat nach Anspruch 12, wobei die zweite Metalloxidschicht durch ALD oder PVD, vorzugsweise durch ALD, gebildet wird.

14. Graphenhaltiges Laminat nach Anspruch 12 oder Anspruch 13, wobei die erste Graphenschichtstruktur durch CVD direkt auf dem Substrat gewachsen ist.

15. Elektronische Vorrichtung, umfassend das graphenhaltige Laminat nach einem der Ansprüche 12 bis 14.

## Revendications

1. Procédé de formation d'un stratifié contenant du graphène, le procédé comprenant :
la fourniture d'une première structure de couche de graphène sur un substrat ;
la formation d'une première couche d'oxyde métallique sur la structure de couche de graphène en déposant puis en oxydant une couche de métal ;
la formation d'une seconde couche d'oxyde métallique sur la première couche d'oxyde métallique ; et
la formation d'une seconde structure de couche de graphène sur la seconde couche d'oxyde métallique par CVD.

2. Procédé selon la revendication 1, dans lequel la seconde couche d'oxyde métallique est formée par dépôt de couches atomiques (ALD) ou par dépôt physique en phase vapeur (PVD), de préférence par ALD en utilisant l'eau comme précurseur d'oxygène et/ou en utilisant un alkyle métallique, un alcoxyde métallique ou un halogénure métallique comme précurseur métallique.

3. Procédé selon une quelconque revendication précédente, dans lequel la première structure de couche de graphène est formée par CVD.

4. Procédé selon une quelconque revendication précédente, dans lequel les deux étapes de formation d'une première et d'une seconde couche d'oxyde métallique sont répétées sur la seconde structure de couche de graphène.

5. Procédé selon une quelconque revendication précédente, dans lequel la première et/ou la seconde couche d'oxyde métallique comprend de l'oxyde d'aluminium, de l'oxyde d'hafnium, de l'oxyde d'yttrium, de l'oxyde de zirconium, de la zircone stabilisée à l'yttria, de l'oxyde de scandium, de l'oxyde de cérium, de l'oxyde de magnésium, de l'oxyde de silicium, de l'oxyde de gallium ou un mélange de deux ou plusieurs de ceux-ci, de préférence de l'oxyde d'aluminium, de l'oxyde d'hafnium, de l'oxyde d'yttrium, de l'oxyde de zirconium, de l'oxyde de cérium ou un mélange de deux ou plusieurs de ceux-ci.

6. Procédé selon une quelconque revendication précédente, dans lequel l'étape d'oxydation de la couche de métal déposé comprend le chauffage de la couche de métal dans un environnement contenant de l'oxygène, de préférence dans une atmosphère consistant essentiellement en oxygène.

7. Procédé selon une quelconque revendication précédente, dans lequel l'étape d'oxydation de la couche de métal déposé comprend le chauffage de la couche de métal sur une plaque chauffante.

8. Procédé selon une quelconque revendication précédente, dans lequel le métal est de l'aluminium ou du hafnium, de préférence de l'aluminium, et/ou dans lequel la couche de métal présente une épaisseur inférieure à 10 nm, de préférence inférieure à 5 nm.

9. Procédé selon une quelconque revendication précédente, dans lequel la seconde couche d'oxyde métallique présente une épaisseur d'au moins 5 nm, de préférence d'au moins 10 nm, et/ou présente une épaisseur inférieure à 50 nm, de préférence inférieure à 30 nm, et/ou dans lequel le rapport entre l'épaisseur de la première couche d'oxyde métallique et l'épaisseur de la seconde couche d'oxyde métallique est de 1:1 à 1:10, de préférence de 1:2 à 1:5.

10. Procédé selon une quelconque revendication précédente, dans lequel la première couche d'oxyde métallique est formée à travers un masque pour fournir une première couche d'oxyde métallique structurée sur la première structure de couche de graphène.

11. Procédé selon une quelconque revendication précédente, comprenant en outre une étape de structuration de la première couche de graphène sur le substrat après l'étape de formation de la première couche d'oxyde métallique et avant l'étape de formation de la seconde couche d'oxyde métallique, de préférence dans lequel l'étape de structuration de la première couche de graphène comprend la gravure plasma de toute partie exposée de la première structure de couche de graphène.

12. Stratifié contenant du graphène comprenant, dans l'ordre :
un substrat ;
une première structure de couche de graphène ;
une première couche d'oxyde métallique, formée par l'oxydation d'une couche de métal ;
une seconde couche d'oxyde métallique ; et
une structure de couche de graphène cultivée par CVD directement sur la seconde couche d'oxyde métallique.

13. Stratifié contenant du graphène selon la revendication 12, dans lequel la seconde couche d'oxyde métallique est formée par ALD ou PVD, de préférence ALD.

14. Stratifié contenant du graphène selon la revendication 12 ou la revendication 13, dans lequel la première structure de couche de graphène est cultivée par CVD directement sur le substrat.

15. Dispositif électronique comprenant le stratifié contenant du graphène selon l'une quelconque des revendications 12 à 14.
